# EUROPEAN PATENT SPECIFICATION

(11) **EP 0 457 443 B1**
(45) Date of publication and mention of the grant of the patent: **29.03.1995**
(21) Application number: 91303595.2
(22) Date of filing: 22.04.1991
(51) Int. Cl.: H01R 13/629, H05K 7/10, H01R 13/193

(54) **Connector**
Verbinder
Connecteur

(30) Priority: 14.05.1990 JP 124487/90
(43) Date of publication of application: 21.11.1991
(73) Proprietor: YAMAICHI ELECTRONICS CO., LTD., Ohta-ku, Tokyo (JP)
(72) Inventor: Matsuoka, Noriyuki, Yokohama-shi, Kanagawa-ken (JP); Uratsuji, Kazumi, Ohta-ku, Tokyo (JP)
(74) Representative: Wood, Anthony Charles

(56) References cited:
- EP-A- 0 095 877
- FR-A- 2 385 238
- IBM TECHNICAL DISCLOSURE BULLETIN, vol. 16, No. 12, 12 May 1974, NEW YORK (US), pp. 3975-3976, R.A. JARVELA 'Module holder and actuator'
- PATENT ABSTRACTS OF JAPAN vol. 12, No. 108 (E-597)(2955) 7 April 1988

## Description

### BACKGROUND OF THE INVENTION

### 1. Field of the Invention

This invention relates to a connector having a moving plate adapted to form a contacting state and a non-contacting state in a connector body.

### 2. Brief Description of the Prior Art

A conventional connector known to the art (see for instance IBM Technical Disclosure Bulletin, vol. 16, n° 12, 12 May 1974, pages 3975-3976) aims at no-load insertion and removal of an IC package to and from an IC socket and includes a movable plate mounted on a connector body, and an operating lever for operating a lateral movement of the movable plate, so that a contacting state and a releasing state can be formed by the lateral movement of the movable plate. Such a connector corresponds to the preamble of claim 1.

By means of operation for pushing down the operating lever, the movable plate is laterally moved in one direction along the upper surface of the connector body. The lateral movement of the movable plate causes the contacts of the connector body to be displaced to a closed state, thereby forming a contact-releasing state relative to the IC leads of an IC package placed on the movable plate so that no-load insertion of the IC package to the IC socket can be obtained. On the other hand, by means of operation for releasing the pushing down, the movable plate is urged by restoring force of the contacts and laterally moved in the opposite direction, thereby forming a contacting state relative to the IC leads.

In recent years, a robot was used in many cases for operation the operating lever in order to enhance workability and to save energy. Therefore, the operating lever is required to have such a construction as that the operating lever can easily be pushed down by means of a vertical movement of a robot.

However, the conventional connector has the following problems. That is, a lever is used as means (operating lever) for moving the movable plate in the lateral direction with a small amount of force. However, the movement of a lever is a pivotal movement, while the movement of a robot is a vertical movement. Since the moving directions are different, the pushing down position of the lever is limited and as a result, the robot is difficult to be operated effectively. Moreover, where a plurality of operating levers are provided to the connector body, these levers must be individually pushed down at the same timing.

The above-mentioned problems also arise where an operating lever or levers are manually operated.

Furthermore, in the above-mentioned prior art, when the contacts are displaced by the reciprocal movement of the movable plate, an electric part mounted on the movable plate is also moved following the movement of the movable plate and therefore, the mounting position of the electric part is changed.

In recent years, since the operation for removing an electric part, especially an IC package, is made by an automation device such as a robot or the like, an accessing position of the automation device is changed if the mounting position is changed. As a result, there occurs a failure in removal of the electric part and mail terminals are deformed because the electric part is removed in its inclined state. Moreover, the change of the mounting position causes the contacting position and the contact-releasing position between the male terminals and contacts to become unstable. As a result, reliability of the contacting relation is badly jeopardized.

The present invention has been accomplished in order to overcome the above-mentioned problems inherent in the prior art.

### SUMMARY OF THE INVENTION

It is therefore a first object of the present invention to provide a connector which can easily cope with automation requirement using a robot.

A second object of the present invention is to provide a connector including a movable plate for displacing contacts, in which the mounting position of an electric part relative to a connector body is always held in a predetermined position so that the mounting and removing operation of the electric part can be properly carried out by an automation device and at the same time, the contacting position and the contact-releasing position of the electric part relative to the connector can be obtained properly.

In order to achieve the above objects, there is essentially provided a connector including a connector body, a movable plate mounted to said connector body, and an operating lever for operating a lateral movement of said movable plate between a contacting state and a contact-releasing state, characterized in that said connector comprising an upper part operating member disposed above said operating lever for movement upward and downward, and a pressure bearing portion formed on one end portion of said operating lever and adapted to carry said upper part operating member, pushing down operation of said upper part operating member causing said pressure bearing portion to be pushed down to move said movable plate in a lateral direction.

According to the connector of the present invention, the operating lever can be pushed down by vertically pushing down the upper part operating member following the vertical motion of a robot. The contacting position between a manipulator of the robot and the upper part operating member is held in a predetermined position and the pushing down operation is performed in that state. Moreover, an operating position for the robot is secured by the upper part operating member, thus enabling to cope with automation requirement using a robot properly.

Furthermore, manual operation can also be performed with ease. For example, where a plurality of operating levers are provided, all of these operating levers can be pushed down at the same timing by the upper part operating member to move the movable plate properly in the lateral direction.

From another aspect of the invention, there is essentially provided, in order to achieve the above objects, a socket comprising a connector body which is held in a stationary state when mounted on a wiring board, etc., a guide erected from said connector body in such a manner as to be projected upward of a movable plate along the side edge portion of a reciprocal motion of said movable plate, said guide regulating both end faces of an electric part at a portion projecting upward of said movable plate, in order to prevent the electric part from following the reciprocal movement of the movable plate and to maintain a relative position.

From still another aspect of the invention, there is essentially provided a socket comprising a connector body, a first guide erected from the connector body, a movable plate and a second guide erected from said movable plate, a loading position of an electric part being established by said first and second guides.

According to the above-mentioned invention, the guide is erected from the connector body in such a manner as to be projected upward of the movable plate exceeding one end thereof, and an electric part is regulated at both end faces thereof by the projecting part of the guide so that the electric part can be loaded in a predetermined position.

Furthermore, when the movable plate is reciprocally moved in order to displace the contacts into a contact-releasing state, the projecting part of the guide erected from one end of the connector body prevents the electric part from moving toward one direction following the movement of the movable plate and the projecting part of the guide erected from the other end of the connector body prevents the electric part from moving toward the other direction following the movement of the movable plate, thereby maintaining the predetermined loading position of the electric part.

As a result, the position of the electric part relative to the connector body is normally held constant and not fluctuated even if the movable plate is moved. Accordingly, there can be obviated such problems as that the electric part is incorrectly taken out or loaded by an automation device, and the male terminals are deformed when the electric part is removed by an automation device.

On the other hand, the movable plate is assured an independent movement for operating to displace the contacts, and a contacting relation and a contact-releasing relation between the male terminals and the contacts can properly be obtained.

Furthermore, by erecting the first guide from the connector body and the second guide from the moving plate, the position of the electric part can more surely be established and the reciprocal movement of the movable plate can properly be performed while maintaining a relative position of the electric part.

The above and other objects and features of the present invention will be more manifest to those skilled in the art upon reading the following detailed description of the embodiment with reference to the accompanying drawing.

### BRIEF DESCRIPTION OF THE DRAWING

Fig. 1 is a perspective view showing one embodiment of a connector according to the present invention;
Fig. 2 is a perspective view of an upper part operating member disengaged from the connector of Fig. 1;
Fig. 3 is a side view of the connector before the upper part operating member is pushed down;
Fig. 4 is a side view of the connector after the upper part operating member is pushed down;
Fig. 5(A) is a sectional view of the connector in which a movable plate is in a position for forming closed state of contacts, and Fig. 5(B) is a plan view showing a positional relationship between an electric part and first and second guides in Fig. 5(A);
Fig. 6(A) is a sectional view of the connector in which the movable plate is in a position for forming an opened state of the contacts, and Fig. 6(B) is a plan view showing a positional relationship between the electric part and the first and second guides in Fig. 6(A); and
Fig. 7(A) is a sectional view of the connector in which the movable plate is in a position for forming a state of terminals clamped by the contacts, and Fig. 7(B) is a plan view showing a positional relationship between the electric part and the first and second guides in Fig. 7(A).

### DETAILED DESCRIPTION OF THE EMBODIMENT

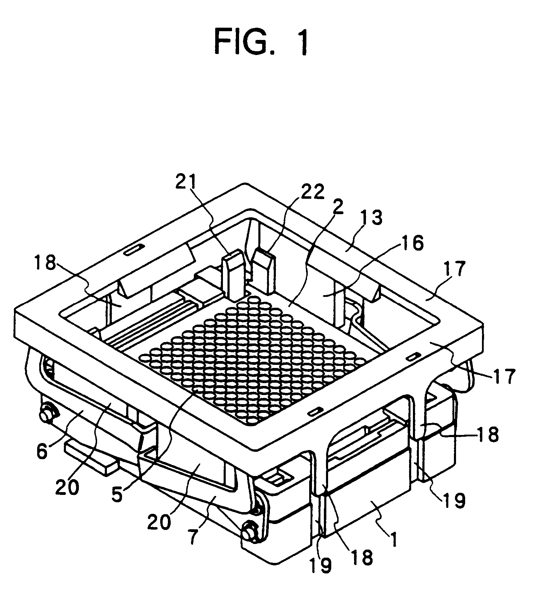

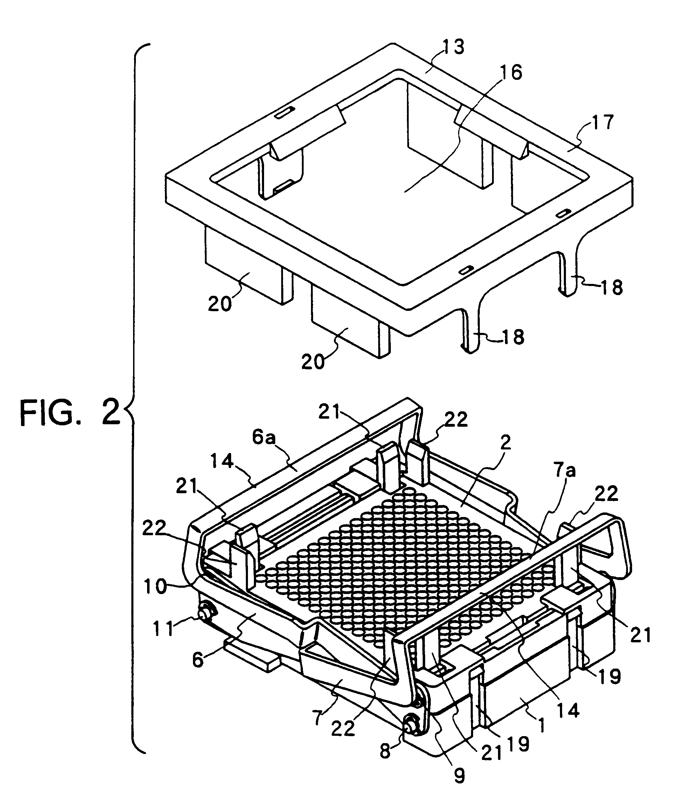

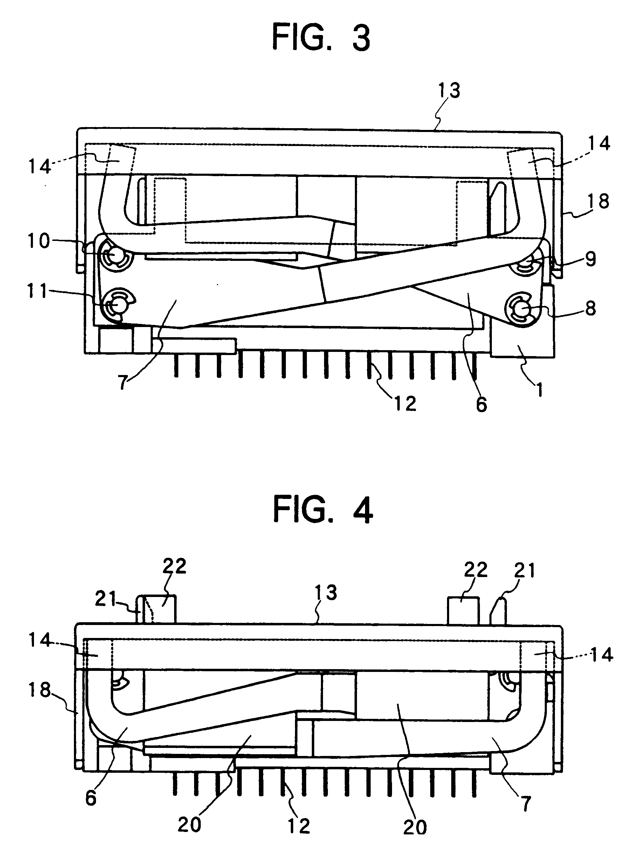

One embodiment of the present invention will be described hereinafter with reference to Figs. 1 through 7.

The numeral 1 denotes a connector body mounted on a wiring board or the like. The connector body 1 has a movable plate 2 which moves along the upper surface of the connector body 1.

The movable plate 2 is superposed on the upper surface of the connector body 1. The movable plate 2 is provided with a plurality of holes 5 for permitting a plurality of male terminals 4 of an electric part 3 to be penetrated therethrough. While placing the electric part 3 on the upper surface of the movable plate 2, the male terminals 4 are penetrated into the terminal penetration holes 5 and the tips of the male terminals 4 are inserted into contact accommodation chambers 15 which are formed in the connector body 1 in such a manner as to correspond to the terminal penetration holes 5. On the other hand, contacts 12 are accommodated in the contact accommodation chambers 15 of the connector body 1 and one contact element of each of the contacts 12 clamping the male terminals 4 is engaged with the movable plate 2. The lateral movement of the movable plate 2 toward the above-mentioned one direction causes the contact element 12a to be displaced against resiliency thereof to bring each of the contacts 12 into an opened state to close thereof. Also, by applying a restoring force of the contact element 12a to the movable plate 2, the movable plate 2 is laterally moved in the other direction to bring each of the contacts 12 in a closed state. No load insertion and removal of the electric part 3 is performed in the above-mentioned opened state of each of the contacts 12, while each of the male terminals 4 are clamped in the closed state.

As means for performing the lateral movement operation of the movable plate 2, the connector of the present invention includes a first operating lever 6 and a second operating lever 7. A lower part of one end of the first operating lever 6 is pivotably axially supported by a supporting shaft 8 at one end of one side surface of the connector body 1, and an upper part of the same end of the operating lever 6 is axially supported by a transmission shaft 9 at one end of the same side surface of the movable plate 2. On the other hand, an upper part of one end of the second operating lever 7 is pivotably axially supported by a supporting shaft 10 at the other end of the same side surface of the connector body 1, and a lower part of the same end of the operating lever 7 is axially supported by a transmission shaft 11 at the other end of the same side surface of the movable plate 2.

The arrangement being such that the transmission shafts 9 and 11 transmit a lateral force directing in one direction to the movable plate 2 when the first and second operating levers 6 and 7 are pivoted downward about the supporting shafts 8 and 10 and transmit a lateral force direction in the other direction to the movable plate 2 when both of the first and second operating levers 6 and 7 are pivoted upward.

That is, the upper and lower positional arrangement of the supporting shaft 8 and the transmission shaft at one end of the first operating lever 6 is in a reversed relation with the upper and lower positional arrangement of the supporting shaft 10 and the transmission shaft 11 at one end of the second operating lever 7.

An upper part operating member 13 is vertically movably disposed above the first and second operating levers 6 and 7, and the operating member 13 is horizontally carried by pressure bearing portions 14 each formed on the first and second operating levers 6 and 7.

The first and second operating levers 6 and 7 extend in the opposite directions with respect to each other along the side surface of the connector body 1. The first operating lever 6 is provided at its free end with the pressure bearing portion 14 adapted to support one end of the upper part operating member 13, while the second operating lever 7 is provided at its free end with the pressure bearing portion 14 adapted to support the other end of the upper part operating member 13. As one modified example, it may be designed such that the first and second operating levers 6 and 7 are arranged in a symmetric relation with respect to each other on both sides of the connector body 1, the free ends of the first and second operating levers 6 and 7 are connected together above the movable plate 2, connection bars 6a and 7a being served as the pressure bearing portions 14.

On the other hand, the upper part operating member 13 has an opening 16 corresponding to the upper surface of the movable plate 2 and exhibits a generally framework configuration as a whole. The electric part 3 is inserted and removed through the opening 16. The upper part operating member 13 is placed a framework element thereof and horizontally carried on the pressure bearing portions 14 formed of the connection bars 6a and 7a. The framework element 17 carried on the connection bar 6a forming the pressure bearing portion 14 has a generally inverted L shape in section, and the connection bars 6a and 7a are engaged with the inner side of the generally inverted L shape of the framework element 17.

The upper part operating member 13 supported by the pressure receiving portion 14 is provided with guide elements 18 extending downward from the framework element 17, and the guide elements 18 are inserted into guide grooves 19 formed at one side surface of the connector body 1. Furthermore, the upper part operating member 17 is provided with guide elements 20 extending downward from the framework 17 which is disposed in parallel relation with the operating levers 6 and 7, and the guide elements 20 are inserted into a crossing part of the operating lever 6. By means of operation of either one or both of the operating guide elements 18 and 20, the vertical upward and downward movement of the upper part operating member 13 is guided and the position of the upper part operating member 13 is secured with respect to the connector body 1 and the operating levers 6 and 7.

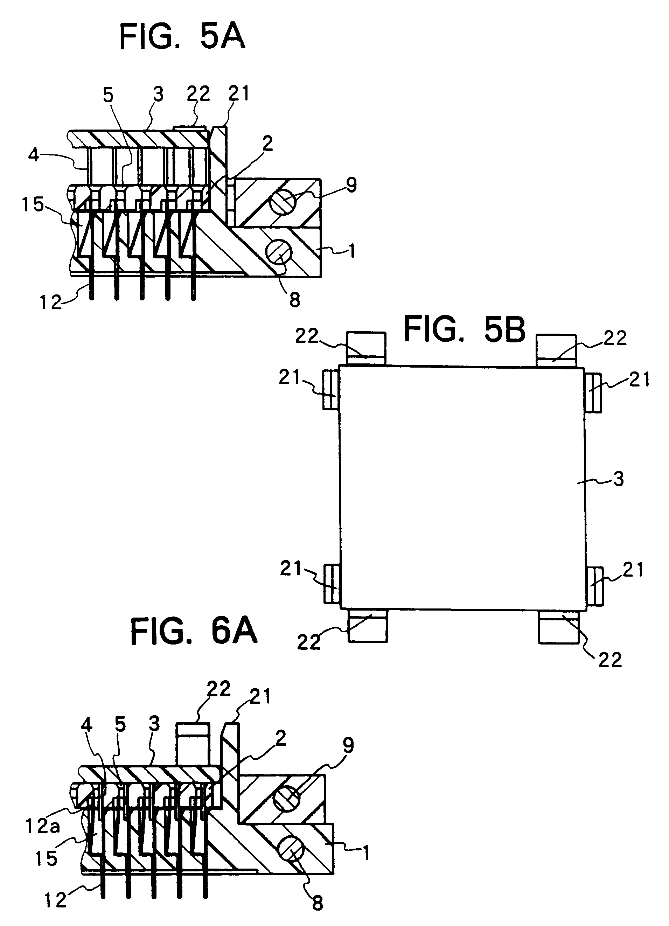

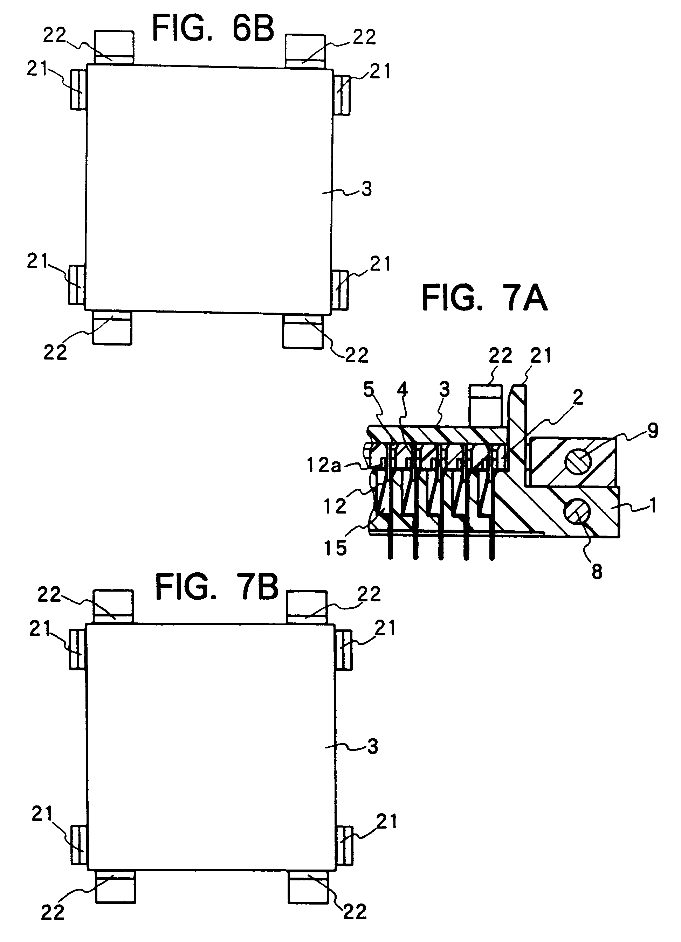

When the upper part operating member 13 is vertically pushed down either by robot or hand, the pushing down force is applied to the pressure receiving portions 14 of the operating levers 6 and 7. As a result, the operating levers 6 and 7 are pivoted downward about the supporting shafts 8 and 10, and the pivotal force is transmitted to the movable plate 2 through the transmission shafts 9 and 11. As a result, the movable plate 2 is laterally moved from a position shown in Fig. 5(A) to a position shown in Fig. 6(A) along the upper surface of the connector body 1. The lateral movement of the movable plate 2 causes the contact elements 12a of the contacts 12 to be displaced against the resilient force to form an opened state. In the opened state of the contacts 12, the electric part 3 is inserted and removed with no-load.

When the pushing down operation of the upper part operating member 13 is canceled, the movable plate 2 is laterally moved in the opposite direction from the position shown in Fig. 6(A) to the position shown in Fig. 5(A) by restoring force of resiliency of the contact elements 12a of the contacts 12. As a result, the contacts 12 are brought into a closed state and the terminals 4 of the electric part 3 are clamped to form a contacting relation.

The connector body 1 is provided with first guides 21 extending upward from corner portions thereof along the end portions of the reciprocal movement side as such that upper ends of the first guides 21 project upward of the movable plate 2. Front and rear end faces of the electric part 3 placed on the movable plate 2 are regulated by the projecting portions of the first guides 21, so that the electric part 3 will not be laterally moved following the lateral movement of the movable plate 2. As a result, the insertion positions of the terminals 4 with respect to the contacts 12 of the connector body 1 are held constant. Furthermore, the connector body 1 is provided with second guides 22 extending upward from the sides perpendicular to the above-mentioned reciprocal movement direction of the movable plate 2 and adapted to move integrally together with the movable plate 12 while regulating the right and left side surfaces of the corner portions of the electric part 3. The first and second guides 21 and 22 regulate the right and left side surfaces of the electric part 22 so that the electric part 22 is held in a predetermined mounting position.

Owing to the foregoing arrangement, the movable plate 2 is reciprocally laterally moved alone to open and close the contacts 12. The electric part 3 is held in a constant position without following the movement of the movable plate 2. As a result, the contacting relation and the contact-releasing relation between the male terminals 4 inserted in predetermined positions and the contacts 12.

The above-mentioned operating lever is only one example. It goes without saying that the present invention can likewise be applied to connectors having various kinds of levers which, when pushed down, move a movable plate in the lateral direction. The invention is of course not limited to two pairs of operation levers, either. Instead, it may be of one pair of operating levers.

As described in the foregoing, the upper part operating member 13 can be vertically downwardly moved, either by robot or hand, following the vertical pushing down operation, and the operating levers 6 and 7 can be operated to pivot downward through the vertical movement of the upper part operating member 13.

Furthermore, the manipulator of the robot and the upper part operating member 13 can perform the above-mentioned pushing down operation without generating displacement in contacting position and while maintaining in a predetermined position. By serving the upper part operating member 13 as a pushing down medium for the operating levers 6 and 7, it can properly cope with the automation requirement using a robot and the pushing down operation by suitable means can also be performed with ease.

Moreover, where a plurality of operating levers are employed, all of them can be pushed down at the same timing by the operating member 13. As a result, the lateral movement of the movable plate 2 and the opening and closing operation of the contacts can properly be performed.

Furthermore, since the mounting position of the electric part 3 is secured by the guides 21 and 22 and is not fluctuated following the movement of the movable plate 2, there can be obviated such problems as that the electric part is incorrectly taken out or loaded by an automation device, and the male terminals are deformed when the electric part is removed by an automation device.

On the other hand, the movable plate 2 is assured an independent movement for operating to displace the contacts 12, and a contacting relation and a contact-releasing relation between the male terminals 4 and the contacts 12 can properly be obtained.

Furthermore, by erecting the first guide 21 from the connector body 1 and the second guide 22 from the moving plate 2, the position of the electric part 3 can more surely be established and the reciprocal movement of the movable plate 2 can properly be performed while maintaining a relative position of the electric part 3.

From the foregoing, it will be seen that a novel and efficient connector has been described herein. The descriptive and illustrative materials employed herein are utilized for purposes of exemplifying the invention and not in limitation thereof. Accordingly, numerous modifications of the invention will occur to those skilled in the art without departing from the scope of the present invention as defined by the claims. Moreover, it is to be understood that certain features of the present invention can be used to advantage without a corresponding use of other features thereof.

## Claims

1. A connector including a connector body (1), a movable plate (2) mounted to said connector body, and an operating lever (6, 7) for operating a lateral movement of said movable plate between a contacting state and a contact-releasing state, characterized in that said connector comprises an upper part operating member (13) disposed above said operating lever (6, 7) for movement upward and downward, and a pressure bearing portion (14) formed on one end portion of said operating lever (6, 7) and adapted to carry said upper part operating member (13), pushing down operation of said upper part operating member (13) causing said pressure bearing portion (14) to be pushed down to move said movable plate (2) in a lateral direction.

2. A connector as claimed in claim 1, characterized in that it comprises two operating levers (6, 7) arranged in symmetric relation at both right and left side surfaces of said connector body (1), free ends of said operating levers being connected together by a bar (6a, 7a), said bar being served as a pressure bearing portion (14).

3. A connector as claimed in claim 1, wherein said upper part operating member (13) has an opening (16) corresponding to an upper surface of said movable plate (2) and exhibits a generally framework configuration as a whole, an electric part (3) being inserted and removed through said opening, said upper part operating member (13) being horizontally carried by said pressure bearing portion (14) of said operating lever (6, 7), the framework element of said upper part operating member (13) being placed on said pressure bearing portion (14).

4. A connector body as claimed in claim 3, wherein said upper part operating member (13) carried on said pressure bearing portion (14) is formed in a generally inverted L shape in section, said pressure bearing portion being engaged with the inner side of the generally inverted L shape of said framework element.

## Patentansprüche

1. Verbinder mit einem Verbinderkörper (1), einer an dem Verbinderkörper befestigten beweglichen Platte (2) und einem Betätigungshebel (6, 7) zur Betätigung einer Querbewegung der beweglichen Platte zwischen einem Kontaktzustand und einem Kontaktfreigabezustand, dadurch gekennzeichnet, daß der Verbinder ein Betätigungsglied (13) des oberen Teils, das über dem Betätigungshebel (6, 7) angeordnet ist, zur Bewegung nach oben und nach unten, und einen drucktragenden Teil (14) umfaßt, der an einem Endteil des Betätigungshebels (6, 7) so ausgebildet ist, daß er das Betätigungsglied (13) des oberen Teils tragen kann, wobei durch den Vorgang des Nachuntenschiebens des Betätigungsglieds (13) des oberen Teils der drucktragende Teil (14) nach unten geschoben wird, um die bewegliche Platte (2) in Querrichtung zu bewegen.

2. Verbinder nach Anspruch 1, dadurch gekennzeichnet, daß er zwei Betätigungshebel (6, 7) umfaßt, die symmetrisch sowohl an der linken als auch an der rechten Seitenfläche des Verbinderkörpers (1) angeordnet sind, wobei die freien Enden der Betätigungshebel über einen Stab (6a, 7a) miteinander verbunden sind, der als drucktragender Teil (14) dient.

3. Verbinder nach Anspruch 1, bei dem das Betätigungsglied (13) des oberen Teils eine Öffnung (16) aufweist, die einer oberen Fläche der beweglichen Platte (2) entspricht und eine allgemein rahmenartige Konfiguration im ganzen aufweist, wobei ein elektrisches Teil (3) durch die Öffnung eingesetzt und herausgenommen wird und das Betätigungsglied (13) des oberen Teils horizontal von dem drucktragenden Teil (14) des Betätigungshebels (6, 7) getragen wird, wobei das Rahmenelement des Betätigungsglieds (13) des oberen Teils auf dem drucktragenden Teil (14) plaziert ist.

4. Verbinderkörper nach Anspruch 3, bei dem das auf dem drucktragenden Teil (14) getragene Betätigungsglied (13) des oberen Teils im Querschnitt allgemein umgekehrt L-förmig ausgebildet ist, wobei der drucktragende Teil mit der Innenseite der allgemein umgekehrten L-Form des Rahmenelements in Eingriff steht.

## Revendications

1. Un connecteur, comprenant un corps de connecteur (1), une plaque mobile (2) montée sur ledit corps de connecteur, et un levier de commande (6, 7), pour commander un mouvement latéral de ladite plaque mobile entre un état de contact et un état de rupture de contact, caractérisé en ce que ledit connecteur comprend un élément de commande de la partie supérieure (13) disposé au-dessus dudit levier de commande (6, 7) pour un mouvement vers le haut et vers le bas, et une portion de support de pression (14) formée sur une première partie d'extrémité dudit levier de commande (6, 7) et apte à porter ledit élément de commande de la partie supérieure (13), une opération de poussée vers le bas dudit élément de commande de la partie supérieure (13) entraînant ladite portion de support de pression (14) à être poussée vers le bas pour déplacer ladite plaque mobile (2) dans une direction latérale.

2. Un connecteur suivant la revendication 1, caractérisé en ce qu'il comprend deux leviers de commande (6,7) arrangés en relation symétrique aux deux surfaces latérales droite et gauche dudit corps de connecteur (1), les extrémités libres desdits leviers de commande étant reliées ensemble par une barre (6a, 7a), ladite barre étant utilisée comme une portion de support de pression (14).

3. Un connecteur suivant la revendication 1, dans lequel ledit élément de commande de la partie supérieure (13) a une ouverture (16) correspondant à une surface supérieure de ladite plaque mobile (2) et présente une configuration générale de cadre dans son ensemble, un composant électrique (3) étant inséré et retiré à travers ladite ouverture, ledit élément de commande de la partie supérieure (13) étant porté horizontalement par ladite portion de support de pression (14) dudit levier de commande (6, 7), l'élément de cadre dudit élément de commande de la partie supérieure (13) étant placé sur ladite portion de support de pression (14).

4. Un corps de connecteur suivant la revendication 3, dans lequel ledit élément de commande de la partie supérieure (13) porté sur ladite portion de support de pression (14) est formé avec une configuration généralement en L inversé en section, ladite portion de support de pression étant en contact avec le côté intérieur de la configuration généralement en L inversé dudit élément de cadre.
